**Europäisches Patentamt**

**European Patent Office**

**Office européen des brevets**

(19)

(11) Veröffentlichungsnummer: **0 156 979 B1**

(12) # EUROPÄISCHE PATENTSCHRIFT

(45) Veröffentlichungstag der Patentschrift:
09.03.88

(51) Int. Cl.⁴: **G 01 N 24/06, A 61 B 5/05**

(21) Anmeldenummer: **84115080.8**

(22) Anmeldetag: **10.12.84**

(54) **Hochfrequenz-Antenneneinrichtung in einer Appparatur zur Kernspintomographie und Verfahren zum Betrieb dieser Einrichtung.**

(30) Priorität: **20.03.84 DE 3410204**

(43) Veröffentlichungstag der Anmeldung:
**09.10.85 Patentblatt 85/41**

(45) Bekanntmachung des Hinweises auf die Patenterteilung:
**09.03.88 Patentblatt 88/10**

(84) Benannte Vertragsstaaten:
**DE FR GB**

(56) Entgegenhaltungen:
**EP - A - 0 071 896**
**EP - A - 0 073 375**
**EP - A - 0 084 946**

**TASCHENBUCH DER HOCHFREQUENZTECHNIK, H. MEINKE et al., Seiten 308-317, 332-335, 462-465, SPRINGER-VERLAG**

(73) Patentinhaber: **Siemens Aktiengesellschaft Berlin und München, Wittelsbacherplatz 2, D-8000 München 2 (DE)**

(72) Erfinder: **Krause, Norbert, Dr., Weinberstrasse 29, D-8551 Heroldsbach (DE)**

## Beschreibung

Die Erfindung bezieht sich auf eine Antenneneinrichtung zur Anregung eines zumindest weitgehend homogenen magnetischen Hochfrequenzfeldes und/oder zum Empfang von entsprechenden hochfrequenten Signalen in einer Apparatur zur Kernspintomographie, in welcher Einrichtung mindestens zwei sich auf einer gedachten Zylindermantelfläche parallel zur Richtung der Zylinderachse erstreckende, gegensinnig stromdurchflossene Leiterstücke vorbestimmter Länge vorgesehen sind, die mit einer externen Energieeinspeisungs- bzw. Vorrichtung verbunden sind. Die Antenneneinrichtung enthält ferner eine rohrförmige, in einem vorbestimmten Abstand konzentrisch bezüglich der gedachten Zylindermantelfläche um die Leiterstücke angeordnete Hülle, die zumindest weitgehend niederfrequenzdurchlässig für magnetische Gradientenfelder ist, elektrisch gut leitendes Material enthält und ebenfalls an die Energieeinspeisungs- bzw. Empfangsvorrichtung angeschlossen ist. Dabei sind die Leiterstücke jeweils an ihrem mit der Energieeinspeisungs- bzw. Empfangsvorrichtung nicht-verbundenen Ende mit die Wellen des Hochfrequenzfeldes reflektierenden Mitteln abgeschlossen, so dass mit dem aus dem Hüllrohr und den Leiterstücken gebildeten Leitersystem ein gleichphasig schwingendes Hochfrequenzfeld auszubilden ist. Eine derartige Antenneneinrichtung geht aus der DE-A-3 133 432 hervor. Die Erfindung betrifft ferner ein Verfahren zum Betrieb dieser Antenneneinrichtung.

Auf dem Gebiet der medizinischen Diagnostik sind bildgebende Verfahren entwickelt worden, bei denen rechnerisch oder messtechnisch integrale Resonanzsignale von Kernen eines bestimmten Elementes eines zu untersuchenden, insbesondere menschlichen Körpers oder Körperteiles analysiert werden. Aus der so zu gewinnenden räumlichen Spindichte- und/oder Relaxationszeitverteilung lässt sich dann ein Bild ähnlich einem Röntgentomogramm konstruieren. Entsprechende Verfahren sind unter der Bezeichnung «Kernspintomographie» (Nuclear Magnetic Resonance Tomography) oder «Zeugmatographie» bekannt.

Für die Kernspintomographie ist ein von einem sogenannten Grundfeldmagneten erzeugtes starkes Magnetfeld Voraussetzung, das in einem Bereich vorbestimmter Ausdehnung möglichst homogen sein soll und in das der zu untersuchende Körper längs einer Achse, die im allgemeinen mit der Orientierungsachse des magnetischen Grundfeldes übereinstimmt, eingebracht wird. Dieses Grundfeld wird von stationären und/oder gepulsten, sogenannten Gradientenfeldern überlagert. Zur Anregung der einzelnen Atomkerne in dem Körper zu einer Präzessionsbewegung ist ausserdem eine besondere Antenneneinrichtung erforderlich, mit der kurzzeitig ein hochfrequentes magnetisches Wechselfeld (HF-Wechselfeld) angeregt werden und auch die damit hervorzurufenden HF-Signale empfangen werden können, falls hierfür keine besondere Messspule vorgesehen wird.

Bei einer solchen Apparatur zur Kernspintomographie (NMR-Apparatur) hängt bekanntlich die Qualität der Schnittbilder von dem Signal-Rausch-Verhältnis des induzierten Kernspinresonanzsignals ab. Da dieses Signal-Rausch-Verhältnis seinerseits von der Stärke des magnetischen Grundfeldes abhängt und mit der Frequenz steigt, ist man bestrebt, bei hohen Grundfeldern möglichst hohe Frequenzen vorzusehen (vgl. «Jour. Phys. E: Sci. Instrum.», vol. 13, 1980, Seiten 38 bis 44).

Mit der aus der eingangs genannten DE-A-3 133 432 bekannten HF-Antenneneinrichtung können HF-Felder mit hohen Frequenzen von etwa 20 MHz oder mehr angeregt bzw. empfangen werden. Hierzu enthält die Antenneneinrichtung ein rohrförmiges Antennenteil aus elektrisch gut leitendem, nicht-magnetischem Material. Dieses Antennenteil stellt eine Hülle um mehrere, mindestens ein Leiterpaar bildende Leiterstücke dar, die auf einer gedachten Zylindermantelfläche liegen, um welche die Hülle konzentrisch in vorbestimmtem Abstand angeordnet ist. Hüllrohr und Leiterstücke weisen etwa gleiche axiale Länge auf. Auf dem mindestens einen Leiterpaar und dem Hüllrohr wird dann mittels einer an sie angeschlossenen Energieeinspeisungsvorrichtung eine Wellenausbreitung mit sehr hoher Frequenz ermöglicht, wobei Resonanzverhältnisse eingestellt werden, so dass im gesamten interessierenden Untersuchungsvolumen gleichphasig schwingende Felder in Form von auf dem Leiterpaar stehenden Wellen ausgebildet werden. Da ferner das gemeinsame Hüllrohr um das Leiterpaar so ausgeführt ist, dass es zumindest weitgehend niederfrequenzdurchlässig ist, können sich in dem Untersuchungsvolumen die niederfrequenten Gradientenfelder entsprechend ungehindert ausbreiten.

Bei dieser bekannten Antenneneinrichtung kann jedoch das HF-Wechselfeld auch Bereiche erfassen, die vor den jeweiligen axialen Stirnseiten des aus den Leiterstücken und dem Hüllrohr gebildeten Leitersystems liegen. D.h. in diesen Bereichen hervorgerufene Störungen können gegebenenfalls das hochfrequente Messsignal verfälschen.

Aufgabe der vorliegenden Erfindung ist es deshalb, die bekannte Antenneneinrichtung gemäss der eingangs genannten Art dahingehend zu verbessern, dass sie weitgehend unabhängig von äusseren Störfeldern ist.

Diese Aufgabe wird erfindungsgemäss dadurch gelöst, dass sich das Hüllrohr in axialer Richtung über die stirnseitigen Enden der Leiterstücke hinaus um ein vorbestimmtes Mass erstreckt, so dass mit ihm eine Rundhohlleiterantenne mit aperiodischer Wellenausbreitung ausgebildet ist, deren Koppelelemente die Leiterstücke sind.

Bei dieser Antenneneinrichtung wird somit über die Leiterstücke, die sich im Bereich der axialen Mitte des als Rundhohlleiter dienenden Hüllrohres befinden, eine hochfrequente Leistung in das Hüllrohr eingekoppelt, wobei sich aufgrund der vorbestimmten Abmessungen des Hüllrohres eine aperiodische Wellenausbreitung einstellt (vgl. z.B. H. Meinke/F. W. Grundlach: Taschenbuch der Hochfrequenztechnik, 3. Auflage, 1968, Seiten 309 bis 316). Da der Durchmesser des Hüllrohres im Verhältnis zur Wellenlänge des hochfrequenten Feldes mit 20 MHz oder höher stets klein ist, lässt sich nämlich diese Rundhohlleiterantenne in einem sogenannten «Cut-Off»-Bereich unterhalb einer bestimmten Grenzfrequenz betreiben, in dem die Ausbreitung des hochfrequenten Feldes praktisch vollständig auf den von dem Hüllrohr umschlossenen Raum begrenzt ist. Die mit dieser Ausgestaltung der Antenneneinrichtung verbundenen Vorteile sind dann darin zu sehen, dass sich auf diese Weise eine Wechselwirkung des hochfrequenten Feldes mit äusseren Störfeldern zumindest weitgehend unterbinden lässt.

Gemäss weiterer Ausgestaltung der Antenneneinrichtung nach der Erfindung kann vorteilhaft in mindestens zwei zu der mittleren Querschnittsebene durch das als Rundhohlleiterantenne dienende Hüllrohr symmetrischen, parallelen Querschnittsebenen jeweils ein zusätzliches Koppelsystem vorgesehen sein. Eine solche Antenneneinrichtung wird vorteilhaft derart betrieben, dass die Phasen- und Amplitudenverhältnisse an den zusätzlichen Koppelsystemen mittels der an sie angeschlossenen Energieeinspeisungsvorrichtung derart eingestellt werden, dass sich die von dem mit den Leiterstücken ausgebildeten Koppelsystem und von den zusätzlichen Koppelsystemen jeweils allein hervorgerufenen Feldstärken zu einer Gesamtfeldstärke überlagern, die ausserhalb des durch die parallelen Querschnittsebenen der beiden zusätzlichen Koppelsysteme begrenzten Bereichs praktisch null ist.

Weitere vorteilhafte Ausgestaltungen der Antenneneinrichtung nach der Erfindung gehen aus den übrigen Ansprüchen 2–10 hervor.

Die Erfindung wird nachfolgend anhand der Zeichnung noch näher erläutert. Dabei zeigen die Fig. 1 und 2 schematisch eine Hochfrequenz-Antenneneinrichtung nach der Erfindung. In Fig. 3 ist eine weitere Ausführungsform einer erfindungsgemässen Antenneneinrichtung schematisch angedeutet, während aus dem Diagramm der Fig. 4 mit dieser Antenneneinrichtung auszubildende Feldstärkeverhältnisse hervorgehen.

Die Hochfrequenz-Antenneneinrichtung nach der Erfindung ist für eine an sich bekannte Apparatur zur Kernspintomographie vorzusehen. Eine solche Apparatur weist im allgemeinen mindestens eine bezüglich der z-Achse eines x-y-z-Koordinatensystems konzentrisch angeordnetes normal- oder insbesondere supraleitendes Feldspulensystem auf, mit dem ein starkes, möglichst homogenes Grundfeld in z-Richtung erzeugt wird. Ausserdem sind Gradientenspulen zur Ausbildung hinreichend konstanter magnetischer Feldgradienten vorzusehen. Die Magnetspulen erlauben einen axialen Zugang zum homogenen Feldbereich in ihrem Zentrum, d.h. der zu untersuchende, insbesondere menschliche Körper oder Körperteil wird längs der z-Achse in das Magnetfeld eingebracht. Die Anregung der Kernspins erfolgt mittels eines senkrecht zur z-Achse gerichteten, möglichst homogenen HF-Feldes.

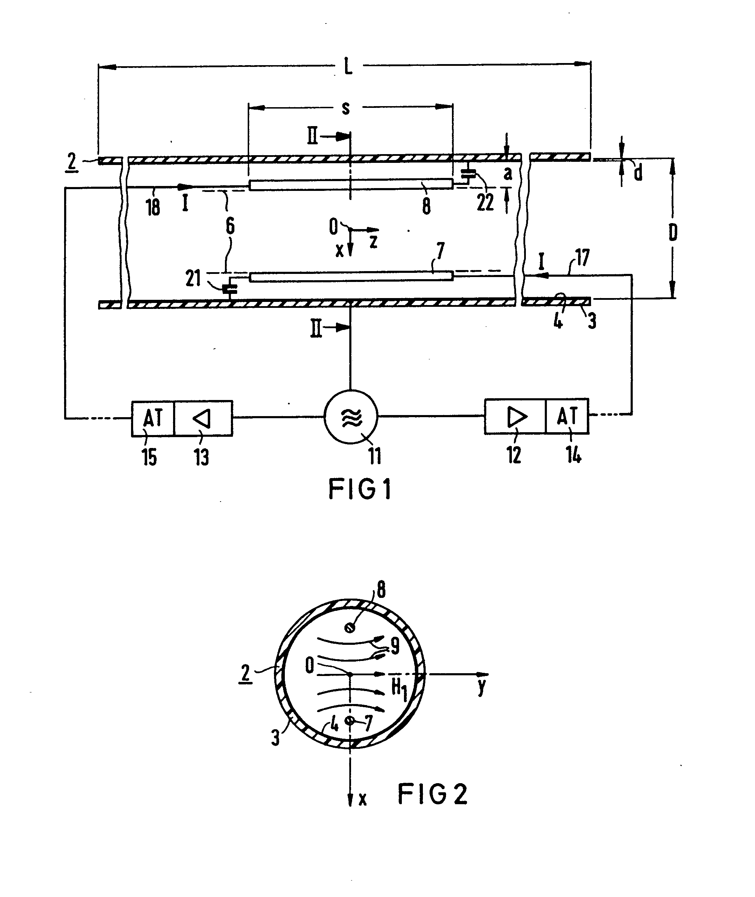

Ein Ausführungsbeispiel einer hierfür zu verwendenden Hochfrequenz-Antenneneinrichtung nach der Erfindung ist in Fig. 1 als Längsschnitt bzw. in Fig. 2 als Querschnitt angedeutet. In den Figuren sind gleiche Bauteile mit den gleichen Bezugszeichen versehen. Die Antenneneinrichtung, bei welcher von der aus der DE-A-3133432 zu entnehmenden Einrichtung ausgegangen wird, enthält ein hohlzylindrisches Hüllrohr 2, dessen Zylinderachse in Richtung der z-Achse eines rechtwinkligen x-y-z-Koordinatensystems weist. Der Koordinatenursprung 0 ist dabei in die axiale Mitte des Hüllrohres gelegt. Dieses Hüllrohr mit einer axialen Länge L und einem Durchmesser D besteht aus einem elektrisch gut leitenden, nichtmagnetischen Material wie z.B. Kupfer und kann gegebenenfalls zumindest auf einer Seite versilbert sein. Beispielsweise wird das Hüllrohr 2 von einem nicht-metallischen, elektrisch isolierenden rohrförmigen Träger 3 gebildet, auf dessen Innenseite eine dünne Kupferfolie oder -schicht aufgebracht ist. Gemäss dem in den Fig. 1 und 2 angenommenen Ausführungsbeispiel wird somit das eigentliche Hüllrohr von dieser Kupferfolie 4 gebildet. Gegebenenfalls kann auch auf der Aussenseite eines entsprechenden Trägerrohres die Kupferfolie angeordnet sein. Da das Hüllrohr ausreichend durchlässig für die niederfrequenten Gradientenfelder sein soll, muss einerseits die Wanddicke d seines elektrisch leitenden Materials verhältnismässig gering sein. Andererseits wird mit abnehmender Dicke der HF-Widerstand des Hüllrohres erhöht, weshalb die Dicke d vorteilhaft grösser als die Eindringtiefe des hochfrequenten Feldes gewählt werden sollte. Im allgemeinen liegt die vorzusehende Dicke d zwischen 10 μm und 50 μm.

Das Hüllrohr 2 umschliesst mehrere auf mindestens einer gedachten Zylinderfläche liegende elektrische Leiter. Der Abstand a zwischen dem Hüllrohr 2 und der dazu konzentrisch angeordneten, durch eine punktierte Linie 6 angedeuteten Zylinderfläche hat einen vorbestimmten Wert. Es lassen sich mindestens zwei ein Leiterpaar bildende Leiterstücke 7 und 8 vorsehen, die eine axiale Länge s aufweisen und gegensinnig von einem Strom I durchflossen werden. Vorteilhaft werden statt einzelner Leiterstücke 7 und 8 jeweils eine vorbestimmte Anzahl von parallelgeschalteten, auf der Zylinderfläche 6 beabstandet nebeneinanderliegenden Leiterstücken verwendet (vgl. die genannte DE-A-3133432).

Mit diesem aus dem Hüllrohr 2 und den Leiterstücken 7 und 8 gebildeten System wird erfindungsgemäss ein durch gestrichelte, gepfeilte Linien 9 angedeutetes hochfrequentes Magnetfeld $H_1$ erzeugt (Fig. 2), das zumindest in dem zentralen Untersuchungsbereich um den Koordinatenursprung 0 weitgehend homogen und senkrecht zur z-Achse gerichtet ist. Hierzu wird von einer in Fig. 1 nur angedeuteten Energieeinspeisungsvorrichtung, welche einen Generator 11, Verstärker 12 und 13 sowie Anpassungstransformatoren 14 und 15 umfasst, sowohl in die Leiterstücke 7 und 8 als auch in das Hüllrohr 2 ein hochfrequenter Strom derart eingespeist, dass sich in diesem System aus Leiterstücken und Hüllrohr stehende Wellen ausbilden, wobei die Resonanz betrieben wird. Wie durch die Strompfeile an den zu den Leiterstücken 7 und 8 führenden Anschlussleitern 17 bzw. 18 angedeutet ist, soll dabei der Strom I in den einander diametral gegenüberliegenden Leiterstücken 7 und 8 in entgegengesetzter Richtung fliessen. In dem gesamten interessierenden Volumen entstehen so gleichphasig schwingende Hochfrequenzfelder. Um für einen Resonanzbetrieb die erforderliche Länge s der Leiterstücke 7 und 8 zu begrenzen, sind in bekannter Weise zwischen dem Hüllrohr 2 und den Leiterstücken 7 und 8 beispielsweise an deren Enden Kapazitäten 21 und 22 mit vorbestimmten Werten vorgesehen (vgl. die genannte DE-A-3133432).

Um das aus den Leiterstücken 7 und 8 und dem sie umgebenden Hüllrohr 2 gebildete System gegen stirnseitige Störeinstrahlungen abzuschirmen, ist erfindungsgemäss die Länge L des Hüllrohres 2 wesentlich grösser gewählt als die Länge s der Leiterstücke 7 und 8. Vorteilhaft ist die Hüllrohrlänge L mindestens doppelt so gross wie die Leiterstücklänge s. Dabei sollen sich das Hüllrohr 2 und die Leiterstücke 7 und 8 symmetrisch zu der durch den Koordinatenursprung 0 verlaufenden Querschnittsebene ($z = 0$) erstrecken. Mit diesen Massnahmen und auf Grund der Tatsache, dass der Durchmesser D des Hüllrohres 2 klein im Verhältnis zur Wellenlänge des HF-Feldes ist, lässt sich nämlich erreichen, dass das Hüllrohr 2 quasi als Rundhohlleiterantenne wirkt, die unterhalb einer bestimmten Grundfrequenz in einem sogenannten «Cut-Off»-Bereich betrieben wird. Die Leiterstücke 7 und 8 stellen dabei für diese Rundhohlleiterantenne im Bereich der durch die Mitte ihrer axialen Ausdehnung sich erstreckenden Querschnittsebene ein System von Koppelelementen zur Ein- bzw. Auskopplung der entsprechenden Hochfrequenzleistung dar. Koppelt man also in der Ebene $z = 0$ des sich von

$$z = -\frac{L}{2} \text{ bis } z = +\frac{L}{2}$$

erstreckenden Hüllrohres eine hochfrequente Leistung ein, so fällt das magnetische HF-Feld gemäss einer Funktion $\exp(-\alpha|z|)$ nach positivem und negativem z hin ab (vgl. das genannte Taschenbuch, Seite 309). $\alpha$ ist dabei ein für den Feldzustand, den sogenannten Mode, im Hüllrohr typischer, frequenzabhängiger Zahlenwert. Besonders günstig für eine Anwendung in der Kernspintomographie ist ein Betrieb in dem sogenannten $H_{11}$-Mode mit einem zur z-Achse transversalen magnetischen Feld $H_1$, wie aus Fig. 2 hervorgeht (vgl. zB. das genannte Taschenbuch, Seiten 332 bis 334).

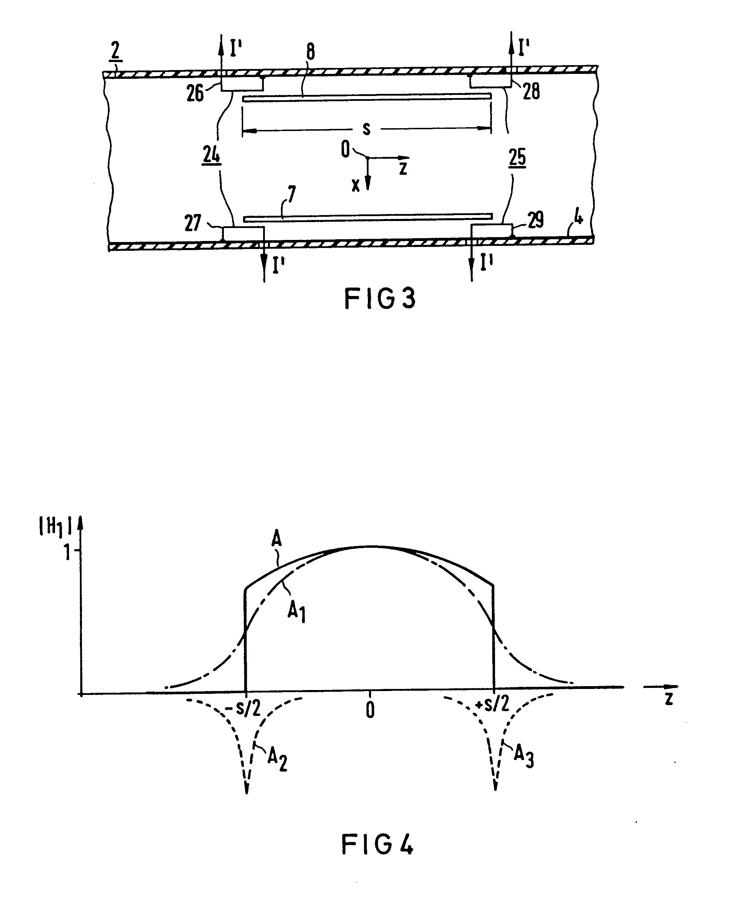

Gemäss dem Ausführungsbeispiel nach den Fig. 1 und 2 wurde davon ausgegangen, dass eine Anregung des als Rundhohlleiterantenne wirkenden Hüllrohres 2 nur in der transversalen Mittelebene ($z = 0$) über ein entsprechendes, aus den einzelnen Leiterstücken gebildetes Koppelsystem erfolgt. Besonders vorteilhaft ist es jedoch, wenn man in mehreren transversalen Ebenen anregt, wobei in jeweils symmetrisch zu der transversalen Mittelebene ($z = 0$) liegenden transversalen Ebenen weitere Koppelsysteme vorgesehen werden. So kann man insbesondere in drei transversalen Ebenen anregen. Eine derartige Anregung ist dem in Fig. 3 schematisch veranschaulichten Längsschnitt durch eine erfindungsgemässe Antenneneinrichtung zugrundegelegt. Dabei sind mit Fig. 1 übereinstimmende Teile mit den gleichen Bezugszeichen versehen.

Die in Fig. 3 gezeigte weitere Ausgestaltung der Antenneneinrichtung nach der Erfindung erhält neben dem mindestens einen Paar von Leiterstücken 7 und 8 im Bereich der die beiden Stirnseiten dieser Leiterstücke begrenzenden Querschnittsebenen

$$\left(z = -\frac{s}{2} \text{ und } z = +\frac{s}{2}\right)$$

jeweils ein Koppelsystem 24 bzw. 25 aus mindestens einem Paar von Koppelelementen 26, 27 bzw. 28, 29. Bei diesen innerhalb eines Systems diametral angeordneten Koppelelementen handelt es sich um an sich bekannte induktive Koppelelemente (vgl. z.B. das genannte Taschenbuch, Seiten 462 bis 465, insbesondere Abbildung 4.4). Diese Koppelelemente sind auf der Innenseite des Hüllrohres 2 bügelförmig, sich in z-Richtung erstreckend gestaltet und einseitig an die dort befindliche elektrisch leitende Wand aus beispielsweise der Kupferfolie 4 angeschlossen. Ihr jeweiliges anderes Ende ist isoliert durch das Hüllrohr 2 hindurchgeführt und über Koaxialkabel mit einer externen, nicht dargestellten Energieeinspeisungsvorrichtung verbunden. Die Anschlüsse der jeweiligen Koppelelemente und damit auch die Durchführungen durch das Hüllrohr sind dabei so angeordnet, dass die durch Pfeile an den Anschlusskabeln angedeuteten Flussrichtungen der Ströme I' in einander gegenüberliegenden Koppelelementen in z-Richtung gesehen entgegengesetzt sind.

Gemäss dem in Fig. 3 gezeigten Ausführungsbeispiel weisen die Koppelsysteme 24 und 25 jeweils nur zwei Koppelelemente 26, 27 bzw. 28, 29 auf. Gegebenenfalls kann aber auch jedes einzelne Koppelelement durch mehrere, gleichsinnig stromdurchflossene Koppelelemente ersetzt werden, so dass dann eine entsprechende Anzahl von Paaren gegensinnig stromdurchflossener, diametral angeordneter Koppelelemente ausgebildet wird (vgl. die genannte DE-A-3133432).

Aus dem in Fig. 4 gezeigten Diagramm gehen die in der Antenneneinrichtung nach Fig. 3 auszubildenden Feldstärkeverhältnisse näher hervor. Dabei soll die im Koordinatenursprung 0 ausgebildete, in x-Richtung weisende Feldstärke einen normierten Betrag $H_1 = 1$ haben. In diesem Diagramm ist der Betrag dieser relativen Feldstärke $|H_1|$ in Längsrichtung des Hüllrohres in Abhängigkeit von der Ortslage auf der z-Achse angegeben. Neben dem zentralen, durch die sich von

$$z = - \frac{s}{2} \text{ bis } z = + \frac{s}{2}$$

erstreckenden Leiterstücke 7 und 8 gebildeten Koppelsystem sind die beiden Koppelsysteme 24 und 25 bei

$$z = - \frac{s}{2} \text{ bzw. } z = + \frac{s}{2}$$

angeordnet. Der sich in dem Hüllrohr ergebende Feldverlauf ohne Verwendung der zusätzlichen Koppelsysteme ist durch eine strichpunktierte, mit $A_1$ bezeichnete Kurve veranschaulicht. Dieser Feldverlauf ergibt sich also auch für die Antenneneinrichtung gemäss den Fig. 1 und 2. Wird jedoch in die einzelnen zusätzlichen Koppelsysteme 24 und 25 in den Bereichen

$$z = - \frac{s}{2} \text{ bzw. } z = + \frac{s}{2}$$

mit einem definierten Phasen- und Amplitudenunterschied gemäss den punktierten Kurven $A_2$ bzw. $A_3$ ein zusätzliches Feld eingespeist, so lässt sich vorteilhaft in den genannten z-Bereichen ein sehr steiler Feldabfall bis praktisch null erreichen. Der entsprechende durch eine durchgezogene Kurve A dargestellte Feldverlauf ergibt sich somit aus einer Überlagerung der von dem zentralen, aus den Leiterstücken 7 und 8 gebildeten Koppelsystem und den zusätzlichen Koppelsystemen 24 und 25 erzeugten Feldformen $A_1$, $A_2$ und $A_3$. Das Feld $H_1$ ist somit für alle z mit $|z|$ grösser

$$\frac{s}{2}$$

praktisch null. D.h. das Feld ist auf eine transversale Schicht der Länge s begrenzt. Auf diese Weise lässt sich vorteilhaft insbesondere eine Rauscheinkopplung aus nicht im Messvolumen liegenden Teilen des zu untersuchenden Körpers unterbinden.

Gemäss dem in Fig. 3 gezeigten Ausführungsbeispiel einer erfindungsgemässen Antenneneinrichtung wurde davon ausgegangen, dass die Koppelelemente 26 bis 29 der zusätzlichen Koppelsysteme 24 und 25 in der gleichen Längsschnittebene durch das Hüllrohr 2 wie die Leiterstücke 7 und 8 liegen. Gegebenenfalls kann man jedoch auch die Koppelelemente in Längsschnittebene anordnen, die mit der die Leiterstücke enthaltenden Längsschnittebene einen vorbestimmten Winkel einschliessen.

**Patentansprüche**

1. Antenneneinrichtung zur Anregung eines zumindest weitgehend homogenen magnetischen Hochfrequenzfeldes und/oder zum Empfang von entsprechenden hochfrequenten Signalen in einer Apparatur zur Kernspintomographie, in welcher Einrichtung

a) mindestens zwei sich auf einer gedachten Zylindermantelfläche parallel zur Richtung der Zylinderachse erstreckende, gegensinnig stromdurchflossene Leiterstücke (7, 8) vorbestimmter Länge vorgesehen sind, die mit einer externen Energieeinspeisungs- bzw. Empfangsvorrichtung verbunden sind,

b) eine rohrförmige Hülle (2) in einem vorbestimmten Abstand konzentrisch bezüglich der gedachten Zylindermantelfläche um die Leiterstücke angeordnet ist, die zumindest weitgehend niederfrequenzdurchlässig für magnetische Gradientenfelder ist, elektrisch gut leitendes Material enthält und ebenfalls an die Energieeinspeisungs- bzw. Empfangsvorrichtung angeschlossen ist, und

c) die Leiterstücke (7, 8) jeweils an ihrem mit der Energieeinspeisungs- bzw. Empfangsvorrichtung nichtverbundenen Ende mit die Wellen des Hochfrequenzfeldes reflektierenden Mitteln abgeschlossen sind, so dass mit dem aus dem Hüllrohr (2) und den Leiterstücken (7, 8) gebildeten Leitersystem ein gleichphasig schwingendes Hochfrequenzfeld auszubilden ist, dadurch gekennzeichnet, dass sich das Hüllrohr (2) in axialer Richtung über die stirnseitigen Enden der Leiterstücke (7, 8) hinaus um ein vorbestimmtes Mass erstreckt, so dass mit ihm eine Rundhohlleiterantenne mit aperiodischer Wellenausbreitung ausgebildet ist, deren Koppelelemente die Leiterstücke (7, 8) sind.

2. Antenneneinrichtung nach Anspruch 1, dadurch gekennzeichnet, dass die axiale Länge (L) des als Rundhohlleiterantenne dienenden Hüllrohres (2) mindestens doppelt so gross wie die entsprechende Länge (s) der Leiterstücke (7, 8) ist.

3. Antenneneinrichtung nach Anspruch 1 oder 2, dadurch gekennzeichnet, dass die einzelnen Leiterstücke (7, 8) symmetrisch bezüglich der axialen Mitte des als Rundhohlleiterantenne dienenden Hüllrohres (2) angeordnet sind.

4. Antenneneinrichtung nach einem der Ansprüche 1 bis 3, dadurch gekennzeichnet, dass das als Rundhohlleiterantenne dienende Hüllrohr (2) eine Folie (4) oder Schicht aus elektrisch gut leitendem Material enthält, die auf der Innen- oder Aussenseite eines aus elektrisch isolierendem Material bestehenden Trägerkörpers (3) aufgebracht ist.

5. Antenneneinrichtung nach einem der Ansprüche 1 bis 4, dadurch gekennzeichnet, dass die Dicke (d) des aus elektrisch leitendem Material bestehenden Teils (Folie 4) des als Rundhohlleiterantenne dienenden Hüllrohres (2) zwischen 10 μm und 50 μm liegt.

6. Antenneneinrichtung nach einem der Ansprüche 1 bis 5, dadurch gekennzeichnet, dass in mindestens zwei zu der mittleren Querschnittsebene ($z = 0$) durch das als Rundhohlleiterantenne dienende Hüllrohr (2) symmetrischen, parallelen Querschnittsebene jeweils ein weiteres System (24, 25) von Koppelelementen (26 bis 29) vorgesehen ist.

7. Antenneneinrichtung nach Anspruch 6, dadurch gekennzeichnet, dass die Koppelelemente (26 bis 29) der weiteren Koppelsysteme (24, 25) im Bereich der Stirnseiten der Leiterstücke (7, 8) angeordnet sind.

8. Antenneneinrichtung nach Anspruch 6 oder 7, dadurch gekennzeichnet, dass jedes zusätzliche Koppelsystem (24, 25) mindestens ein paar von an der Innenseite des als Rundhohlleiterantenne dienenden Hüllrohres (2) angeordneten, sich diametral gegenüberstehenden Koppelelementen (26, 27 bzw. 28, 29) aufweist.

9. Antenneneinrichtung nach einem der Ansprüche 6 bis 8, dadurch gekennzeichnet, dass die Koppelelemente (26 bis 29) bügelförmig gestaltet sind und axial verlaufende Leiterteile aufweisen, die einseitig mit dem elektrisch leitenden Material (4) des als Rundhohlleiterantenne dienenden Hüllrohres (2) elektrisch leitend verbunden sind.

10. Antenneneinrichtung nach Anspruch 9, dadurch gekennzeichnet, dass in jedem zusätzlichen Koppelsystem (24, 25) die Flussrichtungen des Stromes (I') in den axial verlaufenden Leiterteilen der zugehörigen Koppelelemente (26, 27 bzw. 28, 29) entgegengesetzt verlaufen.

11. Verfahren zum Betrieb der Antenneneinrichtung nach einem der Ansprüche 6 bis 10, bei dem die Phasen- und Amplitudenverhältnisse an den zusätzlichen Koppelsystemen (24, 25) mittels der an sie angeschlossenen Energieeinspeisungsvorrichtung derart eingestellt werden, dass die von diesen Koppelsystemen (24, 25) jeweils allein hervorgerufenen Feldstärken ($A_2$ und $A_3$) zusammen mit der von den Leiterstücken (7, 8) allein hervorgerufenen Feldstärke ($A_1$) sich zu einer Gesamtfeldstärke (A) überlagern, die ausserhalb des durch die parallelen Querschnittsebenen der beiden zusätzlichen Koppelsysteme (24, 25) begrenzten Bereiches praktisch null ist.

## Claims

1. An antenna arrangement for exciting an at least substantially homogeneous high-frequency magnetic field and/or for receiving corresponding high-frequency signals in nuclear magnetic resonance tomography apparatus, in which:

a) at least two conductor elements (7, 8) of a specific length are provided, which extend along a surface of an imaginary cylinder parallel to the cylinder axis, and are provided with an external energy supply and receiving device, to be traversed by currents in opposite directions;

b) a tubular casing (2) is arranged at a predetermined distance around the conductor elements, concentric to the imaginary cylinder surface, said casing being substantially transmissive for low-frequency magnetic radiant fields, containing electrically high-conductive material, and being connected to the energy supply and receiving device; and c) the conductor elements (7, 8) are each terminated by means which reflect the waves of the high-frequency field at their end which is not connected to the energy supply and receiving device, so that a high-frequency field which oscillates in-phase can be produced by the conductor array formed from the tubular casing (2) and the conductor elements (7, 8);

characterized in that the tubular casing (2) extends by a predetermined amount beyond the front ends of the conductor elements (7, 8) in the axial direction, to form a circular waveguide antenna for the conductor elements (7, 8) as coupling elements to give periodic wave propagation.

2. An antenna arrangement as claimed in claim 1, characterized in that the axial length (L) of the tubular casing (2), which serves as a circular waveguide antenna, is at least double the corresponding length(s) of the conductor elements (7, 8).

3. An antenna arrangement as claimed in claims 1 or 2, characterized in that the individual conductor elements (7, 8) are arranged symmetrically in relation to the central axis of the tubular casing (2) which serves as a circular waveguide antenna.

4. An antenna arrangement as claimed in one of claims 1 to 3, characterized in that the tubular casing (2), which serves as a circular waveguide antenna, contains a foil (4) or layer of electrically high-conductive material applied to the inside or outside of a carrier component (3) of electrical insulating material.

5. An antenna arrangement as claimed in one of claims 1 to 4, characterized in that the part (foil 4) of electrically high-conductive material of the tubular casing (2) which serves as circular waveguide antenna has a thickness (d) between 10 µm and 50 µm.

6. An antenna arrangement as claimed in one of claims 1 to 5, characterized in that a further system (24, 25) of coupling elements (26 to 29) is provided in at least two parallel cross-sectional planes which are in each case symmetrical to the central cross-sectional plane (z = 0) through the tubular casing (2) which serves as a circular waveguide antenna.

7. An antenna arrangement as claimed in claim 6, characterized in that the coupling elements (26 to 29) of the further coupling systems (24, 25) are arranged in the region of the ends of the conductor elements (7, 8).

8. An antenna arrangement as claimed in claims 6 or 7, characterized in that each additional coupling system (24, 25) comprises at least one pair of coupling elements (26, 27 and 28, 29) arranged diametrically opposite one another on the inside of the tubular casing (2) which serves as a circular waveguide antenna.

9. An antenna arrangement as claimed in one of claims 6 to 8, characterized in that the coupling elements (26 to 29) are U-shaped and are provided with axially extending conductor sections which are electrically conductively connected on one side to the electrically conductive material of the tubular casing (2) which serves as a circular waveguide antenna.

10. An antenna arrangement as claimed in claim 9, characterized in that in each additional coupling system (24, 25) the flow directions of the current (I') oppose one another in the axially extending conductor sections of the associated coupling elements (26, 27 and 28, 29).

11. A method of operating the antenna arrangement claimed in one of claims 6 to 10, wherein the phase and amplitude conditions of the additional coupling systems (24, 25) are adjusted by the energy supply device connected thereto such that the field strengths ($A_2$ and $A_3$), produced by these coupling systems (24, 25) alone, together with the field strength ($A_1$), produced by the conductor elements (7, 8) alone are superimposed to form an overall field strength (A) which is virtually zero outside of the zone delimited by the parallel cross-sectional planes of the two additional coupling systems (24, 25).

**Revendications**

1. Dispositif d'antenne destiné à introduire un champ magnétique à haute fréquence au moins dans une large mesure homogène et/ou pour recevoir des signaux correspondants à haute fréquence dans un appareillage de tomographie à résonance magnétique nucléaire, et dans lequel:

a) il est prévu au moins deux éléments de conducteurs (7, 8), qui s'étendent sur une surface enveloppe cylindrique imaginaire, parallèlement à la direction de l'axe de cette enveloppe cylindrique, sont parcourus par des courants dirigés en des sens opposés et possèdent une longueur prédéterminée et sont reliés à un dispositif extérieur de délivrance ou de réception d'énergie,

b) concentriquement par rapport à la surface enveloppe cylindrique imaginaire et à une distance prédéterminée se trouve disposée, autour des éléments de conducteurs, une enveloppe tubulaire (2) qui est perméable au moins dans une large mesure aux basses fréquences pour des champs magnétiques irrotationnels, contient un matériau bon conducteur de l'électricité et est également raccordé au dispositif de délivrance et de réception d'énergie, et

c) les éléments de conducteurs (7, 8) sont raccordés, respectivement sur leur extrémité non reliée au dispositif de délivrance et de réception d'énergie, à des moyens qui réfléchissent les ondes du champ à haute fréquence, de telle sorte qu'un champ à haute fréquence oscillant en phase doit être formé avec le système de conducteurs constitué par le tube enveloppe (2) et les éléments de conducteurs (7, 8),

caractérisé par le fait que le tube enveloppe (2) s'étend sur une longueur prédéterminée dans la direction axiale au-delà des extrémités frontales des éléments de conducteurs (7, 8), de sorte qu'il forme une antenne à guide d'ondes circulaire qui fournit une propagation apériodique des ondes et dont les éléments de couplage sont les éléments de conducteurs (7, 8).

2. Dispositif d'antenne suivant la revendication 1, caractérisé par le fait que la longueur axiale (L) du tube enveloppe (2) utilisé en tant qu'antenne à guide d'ondes circulaires est égale au moins au double de la longueur correspondante(s) des éléments de conducteurs (7, 8).

3. Dispositif d'antenne suivant la revendication 1 ou 2, caractérisé par le fait que les différents éléments de conducteurs (7, 8) sont disposés symétriquement par rapport à l'axe médian du tube enveloppe (2) utilisé comme antenne à guide d'ondes circulaires.

4. Dispositif d'antenne suivant l'une des revendications 1 à 3, caractérisé par le fait que le tube enveloppe (2) utilisé en tant qu'antenne circulaire à guide d'ondes contient une feuille (4) ou une couche réalisée en un matériau bon conducteur de l'électricité et qui est déposée sur la surface extérieure ou la surface intérieure d'un corps de support (3) réalisé en un matériau électriquement isolant.

5. Dispositif d'antenne suivant l'une des revendications 1 à 4, caractérisé par le fait que l'épaisseur (d) de la partie (feuille 4), réalisée en un matériau électriquement conducteur, du tube enveloppe (2) utilisé en tant qu'antenne à guide d'ondes circulaires est comprise entre 10 μm et 50 μm.

6. Dispositif d'antenne suivant l'une des revendications 1 à 5, caractérisé par le fait qu'il est prévu respectivement un autre système (24, 25) d'éléments de couplage (26 à 29) dans au moins deux plans de coupe transversaux parallèles, symétriques par rapport au plan de coupe transversal médian (z = 0) du type enveloppe (2) utilisé en tant qu'antenne à guide d'ondes circulaires.

7. Dispositif d'antenne suivant la revendication 6, caractérisé par le fait que les éléments de couplage (26 à 29) des autres systèmes de couplage (24, 25) sont disposés au voisinage des faces frontales des éléments de conducteurs (7, 8).

8. Dispositif d'antenne suivant la revendication 6 ou 7, caractérisé par le fait que chaque système supplémentaire de couplage (24, 25) comporte au moins un couple d'éléments de couplage (26, 27 ou 29, 28) diamétralement opposés et disposés sur la face intérieure du tube enveloppe (2) utilisé en tant qu'antenne à guide d'ondes circulaires.

9. Dispositif d'antenne suivant l'une des revendications 6 à 8, caractérisé par le fait que les éléments de couplage (26 à 29) sont réalisés sous la forme d'étriers et possèdent des éléments conducteurs axiaux, qui sont reliés unilatéralement, d'une manière électriquement conductrice, au matériau électriquement conducteur (4) du tube-enveloppe (2) utilisé en tant qu'antenne à guide d'ondes circulaires.

10. Dispositif d'antenne suivant la revendication 9, caractérisé par le fait que dans chaque système supplémentaire de couplage (24, 25), les directions du flux du courant (I') dans les éléments conducteurs axiaux des éléments de couplage associés (26 27 ou 28, 29) sont opposés.

11. Procédé pour faire fonctionner le dispositif d'antenne suivant l'une des revendications 6 à 10, selon lequel les conditions de phases et d'amplitudes dans les systèmes supplémentaires de couplage (24, 25) sont réglées à l'aide du dispositif de délivrance d'énergie, qui leur est raccordé, de telle sorte que les intensités de champ ($A_2$ et $A_3$), pro-

duites individuellement par ces systèmes de couplage (24, 25), sont superposées à l'intensité de champ ($A_1$) provoquée par les éléments de conducteurs (7, 8) seuls, de manière à former une intensité de champ globale (A) qui est pratiquement nulle à l'extérieur de la zone limitée par le plan de coupe transversal parallèle des deux systèmes supplémentaires de couplage (24, 25).

FIG 1

FIG 2

FIG 3

FIG 4